# EUROPÄISCHE PATENTSCHRIFT

(11) **EP 1 330 327 B1**
(45) Veröffentlichungstag und Bekanntmachung des Hinweises auf die Patenterteilung: **17.03.2010**
(21) Anmeldenummer: 01978394.3
(22) Anmeldetag: 02.10.2001
(51) Int. Cl.: B23K 1/20, B23K 1/00, B23K 1/012

(54) **VERFAHREN ZUM FLUSSMITTELFREIEN AUFBRINGEN EINES LÖTMITTELS AUF EIN SUBSTRAT ODER EINEN CHIP**
METHOD FOR APPLYING SOLDER TO A SUBSTRATE OR A CHIP WITHOUT USING FLUX
PROCEDE POUR APPLIQUER UN METAL D'APPORT SUR UN SUBSTRAT OU UNE PUCE, SANS UTILISER DE FONDANT

(30) Priorität: 06.10.2000 DE 10049588
(43) Veröffentlichungstag der Anmeldung: 30.07.2003
(73) Patentinhaber: Pac Tech - Packaging Technologies GmbH, 14641 Nauen (DE)
(72) Erfinder: ZAKEL, Elke, 14612 Falkensee (DE); KASULKE, Paul, 74199 Untergruppenbach (DE); UEBEL, Oliver, 10967 Berlin (DE); TITERLE, Lars, 10999 Berlin (DE)
(74) Vertreter: von Bülow, Tam
(86) Internationale Anmeldenummer: PCT/EP2001/011420
(87) Internationale Veröffentlichungsnummer: WO 2002/028586

(56) Entgegenhaltungen:
- EP-A- 0 557 756
- GB-A- 2 274 286
- US-A- 4 538 757
- US-A- 5 193 738
- US-A- 5 722 581
- US-A- 5 977 512
- PATENT ABSTRACTS OF JAPAN vol. 1997, no. 06, 30. Juni 1997 (1997-06-30) & JP 09 055581 A (TAMURA SEISAKUSHO CO LTD;DAIDO STEEL CO LTD), 25. Februar 1997 (1997-02-25)
- MOSKOWITZ P A ET AL: "THERMAL DRY PROCESS SOLDERING" , JOURNAL OF VACUUM SCIENCE AND TECHNOLOGY: PART A, AMERICAN INSTITUTE OF PHYSICS. NEW YORK, US, VOL. 4, NR. 3, PAGE(S) 838-840 XP000674076 ISSN: 0734-2101 das ganze Dokument
- PATENT ABSTRACTS OF JAPAN vol. 2000, no. 23, 10. Februar 2001 (2001-02-10) & JP 2001 156436 A (UEDA JAPAN RADIO CO LTD;TAISEI KAKEN:KK), 8. Juni 2001 (2001-06-08)
- PATENT ABSTRACTS OF JAPAN vol. 009, no. 087 (M-372), 17. April 1985 (1985-04-17) & JP 59 215267 A (HITACHI SEISAKUSHO KK), 5. Dezember 1984 (1984-12-05)

## Beschreibung

Die Erfindung bezieht sich auf ein Verfahren zum flußmittelfreien Aufbringen eines Lötmittels auf ein Substrat oder einen Chip gemäß dem Oberbegriff des Patentanspruches 1.

Ein solches Verfahren ist beispielsweise aus der US-A-5,193,738 bekannt. Dort wird eine Lötstelle in einer Atmosphäre aus einem Schutzgas oder einem reduzierenden Gas durch Energie eines Lasers gereinigt. Das Gas wird in einen Behandlungsraum eingeblasen und kann durch eine Austrittsöffnung abfließen.

Die EP-A-0 557 756 schlägt zum Reinigen von Lötstellen vor, diese mit aus einem Prozeßgas erzeugten Plasma zu behandeln, das sowohl oxidierende als auch reduzierende Wirkung hat. Das Plasma hat dabei eine Temperatur von 50 bis 200°C.

Weiterhin sind diverse Verfahren zum Vorreinigen von Lötstellen bekannt, bei denen jeweils Gase oder Gasmischungen zum Reinigen verwendet werden. Generell sollen die Gase stets verunreinigungen entfernen und eine Reoxidation verhindern (vgl. GB-A-2 274 286; Moskowitz P.A. et al: "Thermal dry process soldering", Journal of Vacuum Science and Technology: Part A, American Institute of Physics. New York, US, Vol. 4, Nr. 3, S. 838-840 XP000674076 ISSN: 0734-2101; US-A-4,538,757 und US-A-5,722,581).

Die Verwendung eines Plasmas ist auch in Patent Abstracts of Japan, vol. 1997, No. 06, 30. Juni 1997 (1997-06-30) & JP 09 055581 A beschrieben.

In der DE 195 44 929 wird ein ähnliches Verfahren beschrieben. Dort wird ein Bereich auf einer Oberfläche des Substrates oder einer Anschlußfläche des Chips, auf dem ein Lötmittel aufgebracht werden soll, vorbehandelt und insbesondere gereinigt, was durch einen Laserstrahl erfolgt. Verunreinigungen treten dort nämlich überwiegend in Form von metallischen Oxidschichten auf, die durch den Laserstrahl weggebrannt werden. Anschließend oder gleichzeitig wird der vorbehandelte oder gereinigte Bereich durch ein Schutzgas von der Umgebung isoliert und schließlich wird das Lötmittel auf den vorbehandelten und/oder gereinigten isolierten Bereich aufgebracht.

Aus der EP 0 859 681 B1 ist es im gleichen technologischen Zusammenhang bekannt, etwaige Oxidschichten durch eine Vorbehandlung mittels Laserstrahlung von der Verbindungsstelle zu entfernen. Weiter ist dieser Schrift zu entnehmen, zumindest kurz vor und während des Lötens den Lötbereich mit einem Schutzgas zu beströmen, um beim Löten eine inerte Atmosphäre zu schaffen.

Aufgabe der vorliegenden Erfindung ist es, die Reinigungswirkung der bekannten Verfahren noch weiter zu verbessern. Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen.

Grundidee der Erfindung ist es, das verwendete Gas mit zur Reinigung zu verwenden. Das reduzierende Gas wird zur Reinigung verwendet, wie z.B. NH₃ (Ammoniak), Ameisensäuregas, Wasserstoffgas oder sonstige Gase mit Reinigungswirkung, wie z.B. CF₄. Da die Verunreinigungen überwiegend Oxidationsprodukte sind, können sie durch die reduzierenden Gase abgebaut werden. Unter Gas ist auch ein Gemisch verschiedener Gase zu verstehen. Das reduzierende Gas wird ebenfalls vorgeheitz werden, und das Gas von dem zu reinigenden Bereich abgesaugt, wodurch auch Verunreinigungen und insbesondere Reaktionsprodukte des reduzierenden Gases abgeführt werden.

Zusätzlich können die zu reinigenden Bereiche mit weiterer Energie beaufschlagt werden, wie z.B. mit einem Laser-oder Plasmastrahl. Dieses Absaugen erfolgt vorzugsweise mittels einer Kapillare bzw. Düse oder einer Anordnung von mehreren Absaugdüsen.

Auf die so nach der Erfindung gereinigten Bereiche wird dann eine Lotkugel aufgebracht und durch einen Laserstrahl aufgeschmolzen zur Schaffung einer Lötstelle. Da die zu verlötenden Bereiche gereinigt sind, wird kein Flußmittel benötigt und die Benetzungsfähigkeit für Lötmittel, wie z.B. Lötzinn, und damit die Lötbarkeit sind wesentlich verbessert.

## Patentansprüche

1. Verfahren zum Aufbringen eines Lötmittels auf sein Substrat oder einen Chip, bei dem ein Bereich, auf den das Lötmittel aufgebracht werden soll, gereinigt wird, wobei gleichzeitig ein Gas auf diesen Bereich geleitet wird und schließlich ein Lötmittel auf den gereinigten Bereich aufgebracht wird,
wobei die Reinigung durch das Gas erfolgt, und das Gas ein reduzierendes Gas ist, **dadurch gekennzeichnet, daß** das reduzierende Gas vorgeheizt wird, und daß das Gas von dem zu reinigenden Bereich abgesaugt wird und **dadurch** auch die Verunreinigungen und Reaktionsprodukte abgeführt werden.

2. Verfahren nach Anspruch 1, **dadurch gekennzeichnet, daß** das reduzierende Gas Ammoniak, Ameisensäure, Wasserstoffgas oder ein sonstiges Gas mit Reinigungswirkung, wie z.B. CF₄, ist oder ein Gemisch dieser Gase.

3. Verfahren nach einem der Ansprüche 1 bis 2, **dadurch gekennzeichnet,**
**daß** gleichzeitig oder nach dem Anströmen der zu reinigenden Bereiche mit dem Gas diese mit einer weiteren Energie, wie z.B. einem Laser- oder Plasmastrahl beaufschlagt werden.

4. Verfahren nach Anspruch 3, **dadurch gekennzeichnet, daß** das Absaugen mittels einer Kapillare (Düse) oder einer Anordnung von Absaugdüsen erfolgt.

## Claims

1. Method for applying a solder on a substrate or a chip, wherein an area on which the solder is to be applied is cleaned and at the same time a gas is fed onto this area and, finally, a solder is applied on the cleaned area,
wherein the cleaning is made by the gas, and
wherein the gas is a reducing gas,
**characterized in that**
the reducing gas is preheated, and
**in that** the gas is sucked off from the area to be cleaned and thereby also the pollutions and reaction products are discharged.

2. Method according to claim 1, **characterized in that** the reducing gas is an ammonia, formic acid, hydrogen gas or another gas with cleansing effect, as for example CF₄, or a mixture of these gases.

3. Method according to one of the claims 1 to 2, **characterized in that** at the same time or after flowing the gas against the areas to be cleaned these are exposed to an additional energy, as for example a laser beam or a plasma ray.

4. Method according to claim 3, **characterized in that** the suction cleaning is made by means of a capillary (nozzle) or an arrangement of suction nozzles.

## Revendications

1. Procédé d'application d'un métal d'apport sur un substrat ou une puce, dans lequel on nettoie une zone sur laquelle le métal d'apport doit être appliqué, dans lequel en même temps on achemine un gaz sur cette zone et ensuite on applique un métal d'apport sur la zone nettoyée, dans lequel le nettoyage s'effectue par le biais du gaz et le gaz est un gaz réducteur, **caractérisé en ce que** le gaz réducteur est préchauffé et que le gaz est aspiré de la zone à nettoyer, et **en ce que** également, les impuretés et les produits réactionnels sont éliminés.

2. Procédé selon la revendication 1, **caractérisé en ce que** le gaz réducteur est l'ammoniac, l'acide formique, le gaz hydrogène ou un autre gaz ayant une action nettoyante, comme par exemple CF₄, ou un mélange de ces gaz.

3. Procédé selon l'une des revendications 1 à 2,
**caractérisé en ce**
**que**, en même temps ou après l'afflux de gaz dans les zones à nettoyer, celles-ci reçoivent une autre énergie comme par exemple, un rayon laser ou un plasma.

4. Procédé selon la revendication 3, **caractérisé en ce que** l'aspiration s'effectue au moyen d'un capillaire (buse) ou d'un dispositif de buses aspirantes.
